# EUROPEAN PATENT APPLICATION

(11) **EP 2 270 852 A2**
(43) Date of publication of application: **05.01.2011**
(21) Application number: 10167572.6
(22) Date of filing: 28.06.2010
(51) Int. Cl.: H01L 23/373, H01L 23/42

(54) **Thermal interface element and article including the same**

(30) Priority: 30.06.2009 US 494775
(71) Applicant: General Electric Company, Schenectady, NY 12345 (US)
(72) Inventor: Deng, Tao, Clifton Park, NY 12065 (US); Wetzel, Todd Garrett, Niskayuna, NY 12309 (US); Varanasi, Kripa Kiran, Cambridge, MA 02142 (US); Kulkarni, Ambarish Jayant, Niskayuna, NY 12309 (US); Russ, Boris, Niskayuna, NY 12309 (US)
(74) Representative: Illingworth-Law, William Illingworth

(57) **Abstract**

An article 10 and method of forming the article 10 is disclosed. The article 10 includes a heat source 12, a substrate 14, and a thermal interface element 16 having a plurality of freestanding nanosprings 20 disposed in thermal communication with the substrate 14 and the heat source 12. The nanosprings of the article 10 include at least one inorganic material and also at least 50% of the nanosprings have a thermal conductivity of at least 1 watt/mK per nanospring.

## Description

### BACKGROUND

This invention relates generally to a thermal interface element, and more particularly, to a thermal interface element between a device and a substrate in an electronic system.

Electronic systems such as computer systems and communication devices contain high power electrical components generating heat in operation. Due to the requirement of miniaturization, the volume of the electrical components cannot be increased as the power dissipation of the components increases. This presents significant challenges in the management of component temperatures to increase life of the components and to prevent the degradation in performance. Normally heat sinks are used to dissipate heat produced in the components of the electronic systems.

Active and passive heat-sinks comprised of highly thermally conducting materials such as aluminum and copper have been used to conduct heat away from the components the components. As the power dissipation of the components increases, hotspots on the components develop which further complicates thermal management. One way of controlling hotspots is to facilitate the movement of heat from the hotspot to a more advantageously located heat-sink. Newer generation devices such as personal computers, communication devices, and thin-film transistor liquid crystal display (TFT-LCD) adopt a variety of electronic devices that inevitably generate significant quantities of heat. Therefore, efficient heat dissipation is extremely important, and a variety of cooling devices and methods have been developed for this purpose.

Heat dissipation in such devices is traditionally carried out using heat-pipes. Heat-pipes are liquid filled tubes for transferring heat from one end of the tube to the other end of the tube. Further techniques include distributing the heat across more surface area of the devices to control hotspots. More surface area can be achieved by dedicating layers of copper in the devices for conducting heat from the heat-producing component. However, as power dissipation increases, additional layers of copper are required for conducting heat from the component, leaving less area for trace routing for electrical signals or requiring more volume to accommodate the copper layers.

In view of the above-mentioned drawbacks, there is a need for providing a compatible, highly heat dissipating material, design and processes for conducting heat away from the heat producing components in the electronic industry.

### BRIEF DESCRIPTION

One embodiment of the present invention is an article including a heat source, a substrate, and a thermal interface element having a plurality of freestanding nanosprings disposed in thermal communication with the substrate and the heat source. The nanosprings include at least one inorganic material and also at least 50% of the nanosprings have a thermal conductivity greater than about 1 watt/mK per nanospring.

Another embodiment of the present invention is a method of preparing an article. The steps of preparing the article include providing a heat source, providing a substrate, and disposing a thermal interface element comprising plurality of freestanding nanosprings in thermal communication with the substrate and the heat source. In this method, the plurality of nanosprings have at least one inorganic material and at least 50% of the nanosprings have a thermal conductivity greater than about 1 watt/mK per nanospring.

### DRAWINGS

These and other features, aspects, and advantages of the present invention will become better understood when the following detailed description is read with reference to the accompanying drawings in which like characters represent like parts throughout the drawings, wherein:

FIG. 1 is a diagrammatical cross-sectional representation of a system according to one embodiment of the invention.

FIG. 2 is a diagrammatical cross-sectional representation of a system according to one embodiment of the invention.

FIG. 3 is a diagrammatical cross-sectional representation of a system according to one embodiment of the invention.

FIG. 4 is a diagrammatical representation of different nanosprings according to one embodiment of the invention.

FIG. 5 is a scanning electron micrograph of the nanosprings in an example.

### DETAILED DESCRIPTION

Embodiments of the present invention describe an article including a heat source, substrate, and a thermal interface element and an associated method of preparation of the article.

In the following specification and the claims that follow, the singular forms "a", "an" and "the" include plural referents unless the context clearly dictates otherwise.

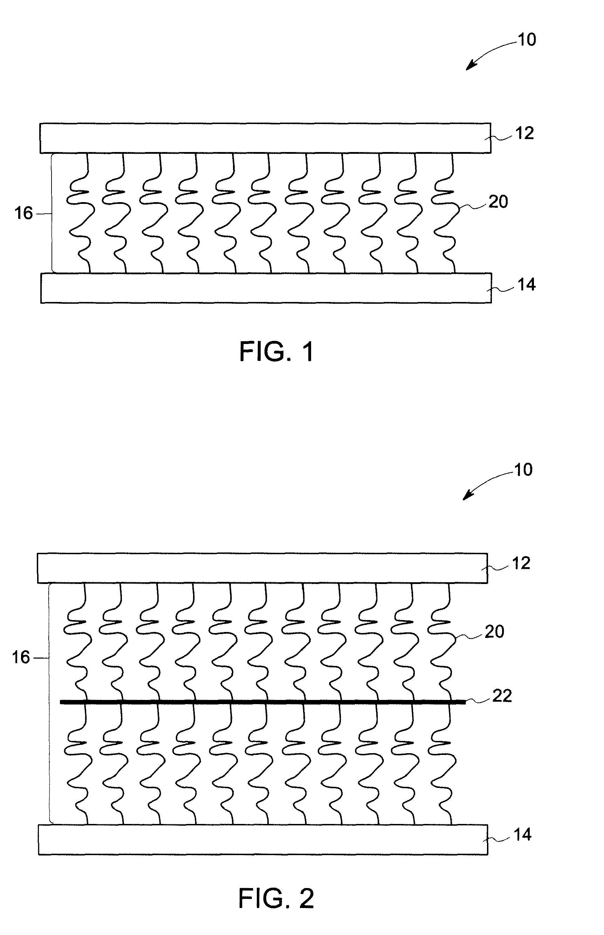

One embodiment of the present invention describes an article having a thermal interface element. The article has the requirement of heat dissipation from at least one component of the article. In one embodiment, heat dissipation can be from one component to another component. FIG. 1 depicts an article 10 including at least one heat source 12 and at least one substrate 14. Heat source 12 is any component of the article that is configured to generate some quantity of thermal energy. Examples of heat sources include heat-generating components of different devices such as optical devices, solar cells, power generation devices, and energy storage devices. In one embodiment, the article is an electronic device. In the electronic device, in one embodiment, the heat source is an electronic component producing heat during operation of the electronic device. In another embodiment, the heat source is a semiconductor chip. In yet another embodiment, the heat source is a printed circuit board (PCB).

In one embodiment, the substrate 14 is a component acting as a heat spreader. A heat spreader can absorb heat from one source and spread to the surrounding or to the selected heat sinks. In another embodiment, the substrate 14 acts as a heat sink. A heat sink is capable of drawing heat from a heat source. In one embodiment, the substrate 14 has a thermal conductivity greater than about 1 watt/mK. In another embodiment, the substrate 14 has a thermal conductivity greater than about 10 watt/mK. The article 10 also comprises at least one thermal interface element 16 that comprises a plurality of nanosprings 20 disposed in thermal communication with the substrate 14 and the heat source 12. As used herein, the term "nanospring" means a structure having at least one dimension that measures less than 10µm and that has an initial shape that is compliant under an applied load and returns to substantially the initial shape upon removal of the load. As used herein, the term "substantially" is accommodative of up to about 5% deviation in the initial shape of the nanosprings. The term "compliant" refers to the quality of having a reversible deformation in a load-unload cycle. "Reversible deformation" is an elastic deformation in the range of about 1% to 1000% of coefficient of thermal expansion (CTE) mismatch of the substrate and heat source.

The thermal interface element 16 is an element that transmits heat from a heat source 12. In one embodiment, the thermal interface element 16 is an element to transmit heat from a heat source 12 to one or more heat sinks. In the article of the present embodiment, the thermal interface element 16 primarily transmits heat from the heat source 12 to the substrate 14. In another embodiment, the thermal interface element 16 also transmits heat to the surroundings (not shown) along with transiting heat to the substrate 14.

In one embodiment, the thermal interface element 16 is a reversibly adhesive element. As used herein and rest of the specification, the term "reversibly adhesive" in context of a thermal interface element described herein, means that the thermal interface element is a structure that can be adhered to and removed from the heat source without damaging the substrate, and the heat source. In general, a component such as the heat source 12 or substrate 14 is considered to be damaged, if the surfaces of 12 and 14 are not further usable for the originally intended application. The adhesiveness of the thermal interface element 16 can be ascribed to the plurality of nanosprings 20. A plurality of nanosprings 20 in physical contact with a surface can be adhered to the surface, for example, through the molecular interactions such as Van der Waals force between the nanosprings 20 and the surface.

According to one embodiment, the plurality of nanosprings 20 is freestanding. As used herein, the term "freestanding" means "without a supporting solid or liquid matrix". Matrix is herein defined as a material disposed in between individual nanosprings 20 within a plurality of nanosprings 20.

In one embodiment, the plurality of nanosprings 20 is disposed on a support. In one embodiment, the substrate 14 of the article itself acts as a support for the plurality of nanosprings 20, while in another embodiment, a separate support can be used to dispose the nanosprings 20. In one exemplary embodiment, as depicted in FIG. 2, the nanosprings 20 are disposed on at least two sides of a support 22. The support 22, along with the nanosprings 20 is positioned between the heat source 12 and the substrate 14 such that the plurality of nanosprings 20 on one side of the support 22 is in thermal communication with the heat source 12 and the plurality of nanosprings 20 in the other side of the support 22 is in thermal communication with the substrate 14.

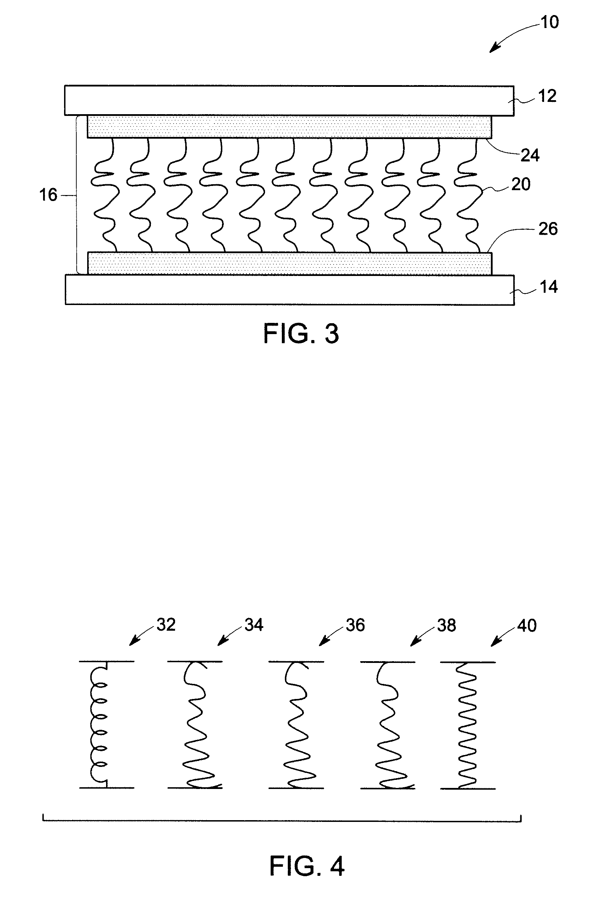

In one embodiment, the nanosprings 20 are in thermal communication with the heat source 12 as well as with the substrate 14. As used herein and rest of the specification, the term "in thermal communication" refers to the ability of an element of the article to conduct heat from another element. Therefore, when the nanosprings 20 are in thermal communication with the heat source 12 and the substrate 14 that works as a heat spreader or heat sink, the nanosprings 20 conduct heat from the heat source 12 to the substrate 14. In one embodiment, the nanosprings 20 are the primary means of heat transfer between the heat source 12 and the substrate 14. The nanosprings 20 may or may not directly receive the heat from the heat source 12 and directly deliver the heat to the substrate 14. There may be intervening materials in between the heat source 12 and / or substrate 14 and the nanosprings 20, for example, as depicted in FIG. 3 in the form of one or more layers 24, 26. In one embodiment, the intervening material between the heat source 12 and / or the substrate 14 and the nanosprings 20 is a thermoelectric material. However, in one specific embodiment, the nanosprings 20 are in contact with the heat source 12 and the substrate 14. In yet another embodiment, the heat source 12 is a thermo electric material and / or the substrate 14 is a thermoelectric material. The term "contact" as used herein means that thermal communication is accomplished without any intervening material other than the material of the heat source 12, substrate 14, the nanosprings 20, and the optional support 22.

In one embodiment, the nanosprings 20 are in dry thermal contact with the substrate 14. As used herein and rest of the specification, the term "dry" means free of any material that, at any point during manufacture or operation, contains sufficient liquid phase so as to enable flow. In another embodiment, the thermal interface element 16 is in dry thermal contact with the heat source 12. In yet another exemplary embodiment, the thermal interface element 16 is in dry thermal contact with the substrate 14 and the heat source 12.

In one embodiment, the nanosprings 20 comprise at least one inorganic material. The inorganic material is any material that does not comprise a carbon-to-carbon bond. In one embodiment, the inorganic material comprises a metallic material, an alloy, a ceramic, or a composite. In one embodiment, the inorganic material comprises copper, aluminum, silver, gold, platinum, tungsten, silicon, zinc oxide, gallium nitride, aluminum nitride, or any combinations of these materials. In another embodiment, the nanosprings 20 comprise one or more organic materials along with inorganic materials. The combination of the organic and inorganic materials may include a composite of organic and inorganic materials. In another embodiment, the nanosprings 20 consists essentially of inorganic materials. In this embodiment, any organic material that may be present is in the form of impurities. In another embodiment, the inorganic material consists of highly thermally conductive metals such as, for example, copper, silver, gold, and platinum.

In one embodiment, more than 50% of the nanosprings 20 of the thermal interface element 16 have a thermal conductivity greater than 1 watt/mK per nanospring, and in certain embodiments this percentage is more than 75%. In another embodiment, more than 50% of the nanosprings 20 have a thermal conductivity greater than 10 watt/mK per nanospring and in certain embodiments this percentage is more than 75%. In yet another embodiment, more than 75% of the nanosprings 20 have a thermal conductivity greater than 100 watt/mK per nanospring.

In one embodiment, the nanosprings 20, on an average, have a cross sectional width less than about 10 micrometers. The " cross sectional width" refers to the largest dimension in a cross section of nanosprings 20 in a direction perpendicular to length of the nanospring at any given point of the nanosprings 20. For example, if a nanospring of certain length is of a regular rectangular shape all throughout the length of the nanospring, the cross sectional width is the diagonal length of the rectangle. In an example with cylindrical nanosprings 20 of different diameters through the length, the cross sectional width is the largest diameter of the nanosprings 20. In another embodiment, the median cross sectional width of the plurality of nanosprings 20 is in a range from about 1 nm to about 10µm. In yet another embodiment, the plurality of nanosprings 20 has a median spring cross sectional width in a range from about 100 nm to about 1µm.

In one embodiment, there can be a number of nanosprings 20 in thermal communication at a particular area of heat source 12 or substrate 14. In general, as the number of nanosprings with physical contact with a surface in a particular area increases, the adhesive force between the nanosprings and the surface also increases. In one embodiment of the present invention, the thermal interface element 16 comprises at least about 10⁵ nanosprings 20 in 1 cm² of area and in another embodiment, the thermal interface element 16 comprises at least about 10⁷ nanosprings 20 in 1 cm² of area, and in yet another embodiment, the thermal interface element 16 comprises at least about 10⁸ nanosprings 20 in 1 cm² of area.

In one embodiment, the plurality of nanosprings 20 comprises at least one nanospring with a curved structure 32 as depicted in the example FIG.4, including at least one curved surface. A curved structure 32 means that the nanospring has at least one curved portion along a length of the nanospring. In one embodiment, at least about 50% of the plurality of nanosprings 20 have a curved structure 32. In another embodiment, at least about 90% of the plurality of nanosprings 20 have curved structure 32. In one more embodiment, at least one nanospring of the plurality of nanosprings 20 has a coiled structure 34. Another embodiment comprises at least about 90% of the nanosprings 20 having a coiled structure 34.

The nanosprings 20 of the thermal interface element 16 can be in thermal communication with the heat source 12 or substrate 14 through different surfaces. For example, the nanosprings 20 can contact the heat source 12 and / or substrate 14 with the ends or through one of the curved surfaces as depicted in structures 36, 38, 40 in FIG.4. In one embodiment, at least about 75% of the plurality of nanosprings 20 contact the heat source 12 and the substrate 14 with the end surfaces of the nanosprings 20 as depicted in structure 40 of FIG.4.

In one embodiment, the plurality of nanosprings 20 has an adhesive force of at least about 0.1 N/cm2 with the heat source 12. In another embodiment, the plurality of nanosprings 20 has at least about 1 N/m² of force with the heat source 12 and with the substrate 14.

Another embodiment of the present invention is a method of preparing an article. The method comprises providing a heat source 12, providing a substrate 14, and disposing a thermal interface element 16 comprising a plurality of freestanding nanosprings 20 in thermal communication with the heat source 12 and the substrate 14. The thermal interface element 16 comprises a plurality of freestanding nanosprings 20 and the nanosprings 20 comprise at least one inorganic material with at least about 50% of the nanosprings 20 have a thermal conductivity of at least about 1 watt/mK per nanospring.

The plurality of nano springs can be disposed in thermal communication with the heat source 12 and the substrate 14 using various methods. For example, the method of disposing the nanosprings 20 can be by any method selected from the group consisting of chemical vapor deposition (CVD), physical vapor deposition (PVD), electro deposition, plasma deposition, sol-gel, micromachining, laser ablation, rapid prototyping, sputtering, or any combination of these methods.

In one embodiment, the plurality of nanosprings was disposed using CVD method. For example, substrate surface can be engineered to alter the wetting during the deposition process. If the substrate surface is altered to reduce wettability of the precursors on the substrate, the deposited material will form spaced-out nuclei. A selective management of the crystal orientation of the nuclei will enable vertical growth of the nuclei with respect to the substrate, instead of forming a film on the substrate. Controlling gas flow conditions, growth dynamics of the precursors, and /or the external influences can alter the growth and orientation of the nuclei and, in turn, help generate nanosprings. For example, inducing a physical or crystallographic strain during growth of the nuclei may help to form curvatures to the nano structures as they grow. Physical or crystallographic strain may be introduced using a number of methods such as, but not limited to, increasing the growth rate, changing the gas flow rate, changing the gas flow direction, applying an external varying electrical field, applying an external varying magnetic field and any combination thereof.

In another embodiment, disposing the thermal interface element 16 includes the steps of disposing a plurality of freestanding nanosprings 20 on at least two sides of a support 22; and inserting the thermal interface element 16 in between the heat source 12 and the substrate 14. For example, the plurality of nanosprings 20 can be disposed on two sides of a rectangular support 22 of a finite thickness by CVD method and the support, along with the plurality of nanosprings 20 extending from the two sides of the support 22 can be inserted between a heat source 12 and a substantially parallel substrate 14 so as to have thermal communication between the heat source 12 and the substrate 14 through the plurality of nanosprings 20.

### EXAMPLE

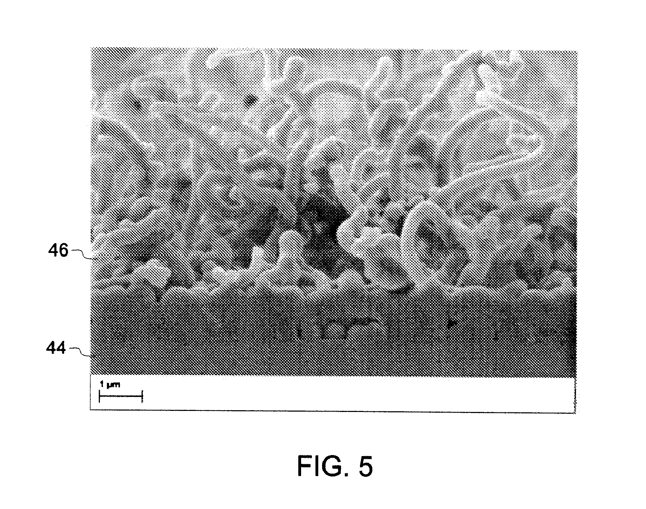

Copper nanosprings were deposited on the silicon substrate by a chemical vapor deposition (CVD) process. Copper powders of about 10µm - -100 µm sizes were used as the source of copper and the deposition was carried out in nitrogen atmosphere at a temperature in the range of about 650°C -900°C. FIG. 5 depicts the scanning electron microscope (SEM) of the copper nanosprings 46 on the silicon substrate 44. Curved copper nanosprings with the median individual diameters less than about 500 nm can be seen in the FIG. 5.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects of the present invention are defined in the following numbered clauses:
1. An article comprising:
   a heat source;
   a substrate; and
   a thermal interface element comprising a plurality of freestanding nanosprings disposed in thermal communication with the substrate and the heat source,
   wherein the nanosprings comprise at least one inorganic material and at least 50% of the nanosprings have a thermal conductivity greater than 1 watt/mK per nanospring.
2. The article of clause 1, wherein the heat source is an electronic device.
3. The article of clause 2, wherein the electronic device comprises a semiconductor device.
4. The article of clause 3, wherein the semiconductor device is at least one chip.
5. The article of any preceding clause, wherein the substrate is a heat spreader.
6. The article of clause 5, wherein the substrate has a thermal conductivity of at least about 1 watt/mK.
7. The article of any preceding clause, wherein the thermal interface element comprises the plurality of nanosprings disposed on a support.
8. The article of clause 7, wherein the thermal interface element comprises the plurality of nanosprings disposed on at least two surfaces of the support.
9. The article of any preceding clause, wherein the thermal interface element is reversibly adhesive to the device and substrate.
10. The article of any preceding clause, wherein the inorganic material comprises a metallic material, an alloy, a ceramic, or a composite.
11. The article of clause 10, wherein the inorganic material comprises copper, aluminum, silver, gold, platinum, silicon, zinc oxide, gallium nitride or any combinations of the foregoing.
12. The article of any preceding clause, wherein the plurality of nanosprings has a median spring cross sectional width in a range from about 1 nm to about 10µm.
13. The article of clause 12, wherein the plurality of nanosprings has a median spring diameter in a range from about 100 nm to about 1µm.
14. The article of any preceding clause, wherein the thermal interface element comprises at least about 10⁵ nanosprings /cm².
15. The article of any preceding clause, wherein the thermal interface element comprises at least about 10⁸ nanosprings /cm².
16. The article of any preceding clause, wherein at least one nanospring has a curved structure.
17. The article of clause 16, wherein at least one nanospring has a coiled structure.
18. The article of clause 16, wherein the at least one nanospring is in thermal communication with the substrate through an end surface of the nanospring.
19. The article of any preceding clause, wherein the pluarality of nanosprings has an adhesive force of at least about 0.1 N/cm² with the heat source and the substrate.
20. The article of any preceding clause, wherein the nanosprings are in dry thermal contact with the substrate.
21. The system of any preceding clause, wherein the thermal interface element is in dry thermal contact with the heat source.
22. The system of any preceding clause, wherein the thermal interface element is in dry thermal contact with the substrate and the heatsource.
23. The article of any preceding clause, wherein at least about 50% of the nanosprings have a thermal conductivity greater than 10 watt/mK per nanospring.
24. The article of clause 23, wherein at least about 75% of the nanosprings have a thermal conductivity greater than 100 watt/mK per nanospring.
25. A method of preparing an article comprising:
   providing a heat source;
   providing a substrate;
   disposing a thermal interface element comprising a plurality of freestanding nanosprings in thermal communication with the heat source and the substrate,
   wherein the pluarality of freestanding nanosprings comprise at least one inorganic material on the substrate, and
   wherein at least about 50% of the nanosprings have a thermal conductivity of at least about 1 watt/mK per nanospring.
26. The method of clause 25, wherein disposing the thermal interface element comprises:
   disposing a plurality of freestanding nanosprings on at least two sides of a support; and
   inserting the thermal interface element in between the heat source and the substrate.
27. The method of clause 25 or clause 26, wherein disposing the plurality of nano springs is by any method selected from the group consisting of chemical vapor deposition (CVD), physical vapor deposition (PVD), electro deposition, plasma deposition, sol-gel, or any combination thereof.

## Claims

1. An article (10) comprising:
a heat source (12);
a substrate (14); and
a thermal interface element (16) comprising a plurality of freestanding nanosprings (20) disposed in thermal communication with the substrate (14) and the heat source (12),
wherein the nanosprings (20) comprise at least one inorganic material and at least 50% of the nanosprings have a thermal conductivity greater than 1 watt/mK per nanospring.

2. The article (10) of claim 1, wherein the heat source (12) is an electronic device.

3. The article (10) of claim 1 or claim 2, wherein the substrate (14) is a heat spreader.

4. The article (10) of any preceding claim, wherein the thermal interface element (16) comprises the plurality of nanosprings (20) disposed on a support (22).

5. The article (10) of any preceding claim, wherein the thermal interface element (16) is reversibly adhesive to the device and substrate (14).

6. The article (10) of any preceding claim, wherein the inorganic material comprises a metallic material, an alloy, a ceramic, or a composite.

7. The article (10) of any preceding claim, wherein the thermal interface element (16) comprises at least about 10⁵ nanosprings /cm².

8. The article (10) of any preceding claim, wherein the thermal interface element (16) is in dry thermal contact with the substrate (14) and the heat source (12).

9. A method of preparing an article (10) comprising:
providing a heat source (12);
providing a substrate (14);
disposing a thermal interface element (16) comprising a plurality of freestanding nanosprings (20) in thermal communication with the heat source (12) and the substrate (14),
wherein the pluarality of freestanding nanosprings (20) comprise at least one inorganic material on the substrate (14) , and
wherein at least about 50% of the nanosprings have a thermal conductivity of at least about 1 watt/mK per nanospring.

10. The method of claim 9, wherein disposing the plurality of nano springs (20) is by any method selected from the group consisting of chemical vapor deposition (CVD), physical vapor deposition (PVD), electro deposition, plasma deposition, sol-gel, or any combination thereof.
